(19) Europäisches Patentamt / European Patent Office / Office européen des brevets

(11) **EP 2 811 330 A1**

(12) **EUROPEAN PATENT APPLICATION**
published in accordance with Art. 153(4) EPC

(43) Date of publication:
**10.12.2014 Bulletin 2014/50**

(21) Application number: **13743690.3**

(22) Date of filing: **24.01.2013**

(51) Int Cl.:
**G02B 26/00** $^{(2006.01)}$    **G02B 6/35** $^{(2006.01)}$
**H04B 10/25** $^{(2013.01)}$    **G02B 23/00** $^{(2006.01)}$

(86) International application number:
**PCT/ES2013/070029**

(87) International publication number:
**WO 2013/113959 (08.08.2013 Gazette 2013/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.01.2012 ES 201230123**

(71) Applicant: **Perez Rodriguez, Daniel Enrique**
**28903 Getafe (Madrid) (ES)**

(72) Inventor: **Perez Rodriguez, Daniel Enrique**
**28903 Getafe (Madrid) (ES)**

(74) Representative: **Munoz Garcia, Antonio**
**Consiangar, S.L.**
**Albasanz, 72 1º-1**
**28037 Madrid (ES)**

(54) **MODULAR, ADAPTIVE OPTICAL CAPTURE AND DISTRIBUTION EQUIPMENT**

(57) The present invention relates to modular, adaptive optical capture and distribution equipment, comprising rigid or flexible and inflatable optical manipulator elements, formed by devices suitable for gathering light and channeling it to guide means (7) in order to convey said light to the location where it is required, and controlling the focusing and the intensity of the light output; said manipulator elements (1) are simple and formed by a hollow conical body (4) with a base (5), the tip (6) of which has a high refractive index and the remainder being reflective; or double-reflection optical manipulator elements (2) formed by a round body (8), which may be spherical or parabolic, among other shapes, with two mirrors, a larger mirror (9) and another smaller mirror (11), and optionally they are combined with a simple optical manipulator element (1); or composite optical manipulator elements (3), formed by grouping together, as modules, simple optical manipulators elements (1) and/or double-reflection optical manipulator elements (2).

FIG.6

**Description**

Object of the Invention

As expressed in the title of the present specification, the invention relates to a modular, adaptive optical capture and distribution equipment, providing several novel features and advantages to its intended function that will be described in detail below and involve significant improvement with respect to systems known today for the same purpose.

More particularly, the object of the' invention is equipment comprising different types of modules or devices suitable for gathering light and channeling it to light guiding means which convey it to the location where it is required, which modules and devices, according to their configuration, are divided into simple optical manipulator elements, double-reflection optical manipulator elements or composite manipulator elements formed by modular groups of one or both types of the mentioned manipulators, and said modules and devices, which can be of a rigid or inflatable and flexible structure, allow controlling the focusing and the intensity of the light output for adapting it to the needs of each application.

Field of Application of the Invention

The field of application of the present invention is comprised within the sector of solar collectors, particularly covering the industry dedicated to the manufacture of both rigid and inflatable optical distributors and collectors with the function of capturing light from astronomical objects, including the sun, and from any other source such as laser light, electric light, etc., for use either as solar collectors to generate energy of as a lighting system or for use as telescopes.

Background of the Invention

Today, techniques using sunlight as an energy source are basically:

- Thermal solar energy (direct application, in solar-powered engines or Stirling engires).
- Electric energy produced directly from solar energy (solar cell panels and solar-powered turbines).

The technique considered in the present invention is both thermal and electric solar energy. A wide variety of solar energy collectors-concentrators have been produced in this technique, including the inflatable solar energy collectors described in patents CN2758656 (Y), FR2567995 (A1), GB2457701 (A), US4182307 (A). However, the inflatable solar collectors in most of these patents and in other patents relating to said collectors are rather impractical due to the mistake of attaching them to the inflatable collectors and apparatus converting sunlight into other forms of energy, generally electricity, without taking into account that the heat generated in the process is the worst enemy of the plastic material used to make the collectors because it melts it.

In addition, patents CN201038321 (Y) and DE19923141 (A1) disclose inflatable telescopes which are designed with wire structures similar to that of umbrellas, causing them to have a limited size and complicating their opening, particularly if they have to be opened in bad weather. Another example is that described in patent CN 2768032 (Y), which is not very large in size since it is a simple toy.

As is known, solar energy is a clean and renewable energy source, but the costs of current techniques for using it are very high, making it rather uncompetitive with respect to hydrocarbons and atomic energy as an energy source. In addition, inflatable telescopes today are very troublesome in terms of transporting them on foot up a mountain, which is the ideal location, away from the city to avoid light contamination. Furthermore, there is a practical need to be able to transport a telescope that has a primary mirror with a considerably large diameter and fits in a bag or backpack.

The object of the present invention is to solve both drawbacks, as it provides a new, more economical technique, not only for gathering and concentrating either sunlight or celestial light, but rather for manipulating it with high flexibility, channeling and focusing it to where it will be used. All this can be achieved at a low cost.

It must also be pointed out that the applicant is unaware of the existence of any other optical capture and distribution equipment or of any other invention of a similar application, having thermal, structural and constitutive features similar to those of the equipment herein proposed and claimed.

Brief Description of the Invention

The modular, adaptive optical capture and distribution equipment proposed by the invention is configured specifically and in accordance with its implantation as a remarkable novelty within its field of application, since said implantation provides economical and simple means for capturing light in large areas; said equipment allows using solar energy in an economically feasible and competitive manner with respect to current technologies based on elements that are both light collectors and diffusers called optical manipulators, guide means for guiding light and other commonly used optical apparatus.

Another objective of and optical capture and distribution equipment is a new type of lightweight inflatable telescope that is highly portable, economical and has a primary mirror with a considerably large diameter. Depending on the requirement, the set of optical manipulators will be adapted to needs. They can be used, for example, as telescopes used at night or for industrial purposes to apply sunlight as an energy source.

Specifically, as described above the invention proposes equipment comprising different types of optical devices suitable for gathering light and channeling it to guide means for guiding light, conveying it to the location where it is required, and according to the configuration, said elements are divided into simple optical manipulator elements, double-reflection optical manipulator elements and composite manipulator elements which are formed by modular groups of several simple and/or double-reflection manipulator elements.

In a simplified manner, as a more detailed explanation will be provided below, the simple optical manipulator elements and the guide means are formed by a conical-shaped body with a base and a tip having a high refractive index, whereas the rest of the inner surface is reflective and has lower refraction.

The double-reflection optical manipulator elements are in turn formed by a round body (spherical, spheroid, ovoid or paraboloid) with at least two mirrors, one which is called larger mirror located on the inner surface of a smaller half sphere or parabola, concentrating the gathered light on its focal line or point/points on an equatorial plane or a plane parallel to same, where a membrane, film or lightweight support equipment, for example, formed by nylon lines or small plastic films, support the other mirror (or mirrors), which is called smaller mirror and which in turn reflects the light for channeling it either directly to guide means or optionally through a simple optical manipulator, arranged for such purpose in the center of the larder mirror or in its vicinity, where the light is guided, distributed and diffused with the focus and power suited for use. For the latter purpose, the invention also has suitable optical manipulaltors and optical element.

It must be pointed out that the smaller mirrors are classified into two types: short smaller mirrors with shapes ranging from a circular shape to other shapes such as a square shape, star shape, etc., for gathering light from a specific time and location, and elongated smaller mirrors with shapes ranging from an oval shape to other shapes such as a rectangular shape, a vertical pupil (such as the pupil of eats' eyes), etc., for gatherint sunlight throughout the day without having to move the optical manipulator to follow the sun.

Logically, both the simple optical manipulator elements and the double-reflection optical manipulator elements can be supported by bases of any shape or material.

The composite optical manipulator elements comprise a panel in which there are incorporated several simple and/or double-reflection optical manipulator elements, the respective guide means and tubing, where appropriate, being grouped together as main guide means and tubing which allows acting on the set.

In any case, the optical manipulator elements can be made of a rigid structure, preferably glass, metals or alloys thereof, rigid molded plastics or similar materials, or very flexible materials, preferably plastic materials, latex or materials similar to both, which can be inflatable, in which case they increase the adaptability possibilities for controlling the focusing and intensity of the light output, the chambers of the optical manipulator being adapted to changes in atmospheric pressure since the internal pressure of the chambers can be controlled through the tubing provided for inflating and deflating same, the chambers being inflated with a gas or gas mixture, or with a liquid or liquid mixture, and their shape thus being modified for improved focusing.

All flexible, inflatable optical manipulators can be manufactured using plastic moulding machines, such as injection machines or plastic laminating machines, and rigid optical manipulators can be manufactured by glass blowing machines, by braziers, metalworkers, smelting experts or robots performing the same work.

An example of how inexpensive solalr thermoelectric energy can be would be to use a double-reflection optical manipulator with an elongated signaller mirror as a source for gathering solar energy, which does not require any type of costly mechanism such as solar trackers. The only thing that will be required is for the Fresnel-type smaller mirror with an elongated shape like a vertical pupil to capture sunlight all day, and by simply orienting it in the East-West direction using a simple compass or by simply viewing the direction of shadows over the course of the day. The costs for gathering and managing solar energy to enable using it directly (in industrial foundries and furnaces), or in any form of work (using a solar-powered engine or Stirling engine), or as an economical source of electric energy (using a solar-powered turbine), are therefore greatly reduced.

An example of how a double-reflection optical manipulator of the type having an elongated smaller mirror can be used in industry is described below. By using a weather balloon as a base to make an optical manipulator with a modest volume of 10,000 $m^3$ (there are much bigger balloons), the following is obtained:

The amount of energy that arrives to the surface of the Earth from the sun is about 0.5 $kW/m^2$ to 1 $kW/m^2$, therefore the double-reflection optical manipulator having:

Volume: 10,000 $m^3$

$$V = (4 * \pi * r^3) / 3 \Rightarrow r^3 = 3V / 4\pi \Rightarrow r = \sqrt[3]{3V/4\pi}$$
$$= 13.37 \text{ m}$$

Therefore, on the half sphere surface

$$S = (4 * \pi * r^2) / 2 = 1{,}123.16 \text{ m}^2$$

$$E = S * W/m^2 = 1{,}123.16 \text{ m}^2 * 1 \text{ kW}/m^2 = 1{,}123.16 \text{ kW}$$

$$E = S * W/m^2 = 1{,}123.16 \text{ m}^2 * 0.5 \text{ kW}/m^2 = 561.58 \text{ kW}$$

Therefore, a single double-reflection optical manipulator element of a volume of 10,000 m$^3$ having these values of 561.58 kW to 1,123.16 kW, if they are multiplied by the number of optical manipulators required (those that could be placed, for example, floating and tethered on the roofs of sheds and parking lots of any company), there would be enough energy to enable a company to work during the day, and hydrogen manufactured with the surplus energy can be used at night without having to resort to hydrocarbons or to electric energy from a nuclear power plant.

Furthermore, the economical cost is only a little more than a weather balloon to which there is added a membrane of the same material as the balloon located at the equator of the balloon, separating it into two chambers. said membrane has, stomped and painted along the length and width of the focal line of the larger minor, the smaller mirror, so said mirror is lightweight. The drawback to be highlighted would be a short service life; however, it would be further compensated for by the amount of energy captured.

Manufacturing said manipulator from a weather balloon is in turn rather simple. Weather balloons are made from plastic materials such as polyethylene polyethylene terephthalate (better known as PET) or multilayer compositions of other compounds derived from these. There are also weather balloons that are made from latex, chloroprene and the like.

Generally, they are films with a thickness of hardly a few microns and are therefore extremely lightweight and resistant, though delicate to andle. However, to make an optical manipulator based on the technology for making weather balloons, the use of thicker films is recommended to increase hardness and durability, since it will result in a tethered balloon having 2, 3 or more inner chambers.

Therefore, for manufacturing a spherical double-reflection optical manipulator of the type having an elongated smaller mirror based on the technology for manufacturing weather balloons, the process to be followed is the following: the plastic material described above is cut into strips, the strips are formed into clusters which are then joined to one another using heat plus a specially formulated adhesive; however, they must be glued together along a curve to obtain a sphere. By using this same technique, and when more than two thirds of the balloon is done, the equatorial membrane containing the smaller mirror is glued and the simple optical manipulator is incorporated at the bottom of the balloon; then the making of said optical manipulator continues until it is done. Their cavities are then inflated with different gases for the spherical double-reflection optical manipulator and for the simple optical manipulator, where appropriate; they could also be inflated with liquids.

Another example of a possible use of a spherical double-reflection optical manipulator of the type having a short smaller mirror is as a telescope since it is rather lightweight, easy to transport install and use, with a primary mirror of a considerably large size, the larger mirror having a diameter of two meters.

In view of the foregoing, it must be stated that the described modular, adaptive optical capture and distribution equipment represents an innovation having features unknown up until now for such purpose, which reasons along with its practical usefulness give it sufficient grounds for obtaining the exclusive privilege that is sought.

Description of the Drawings

To complement the description of the invention that is being made and to help better understand the features distinguishing it, a set of drawings is attached to the present specification as an integral part thereof, in which the following is depicted with an illustrative and nonlimiting character:

Figure 1 shows a schematic perspective view of an embodiment of a simple optical manipulator element of the modular, adaptive optical capture and distribution equipment object of the invention, the parts and elements forming same being seen therein.

Figures 2A, 2B and 2C show three perspective views of the example of a simple optical manipulator element shown in Figure 1, depicted respectively with three different types of base, i.e., concave, planar and convex base, adapted by means of inflation pressure control.

Figures 3A and 3B show respective side and front views of a schematic example of a spherical double-reflection optical manipulator element of the type having a short smaller mirror and therefore with the small simple optical manipulator element attached to it.

Figures 4A and 4B also show respective side and front views of another example of a spherical double-reflection optical manipulator element, in this case of the type having an elongated smaller mirror and therefore with the simple optical manipulator element of considerable size attached to it.

Figures 5 and 6 show respective side views of an example of a double-reflection optical manipulator element of the type having a short smaller mirror with a parabolic configuration and an example of a double-reflection optical manipulator element having a short smaller mirror with a spherical configuration, the difference between both types of optical manipulators being seen therein.

Figures 7A and 7B show respective front and side views, respectively, of an example of a composite optical manipulator element formed only by several simple optical manipulator elements, the arrangement thereof and the components grouping them together being seen.

Figures. 8A and 8B show respective front and side views, respectively, another example of a composite optical manipulator element, in this case formed only by several double-reflection optical manipulator elements, the arrangement thereof and the components grouping them together being seen.

Figures 9A and 9B show respective front and side views, respectively, of a third example of a composite optical manipulator element, in this case of a mixed type, i.e., formed by simple optical manipulator elements and double-reflection optical manipulator elements, the arrangement thereof and the components grouping them together being seen.

Preferred Embodiment of the Invention

In view of the mentioned drawings and according to the adopted numbering, a preferred embodiment of the invention which comprises the parts and elements that are described in detail below can be seen.

As observed in said drawings, the equipment of the invention consists of a set of optical elements, called optical manipulators, applicable for capturing light from any source (solar, stellar, galactic electric, boreal, etc.), and for being used as a solar collector for generating energy, or as a telescope, comprising three basic types of such optical manipulator elements which, formed by devices suitable for gathering light and channeling t to guide means in order to convey said light to the location where it is required depending on the configuration thereof, allow controlling the focusing and intensity of the light output through another or other optical manipulator/manipulators and/or through other optical elements.

Therefore, said optical manipulator elements are:

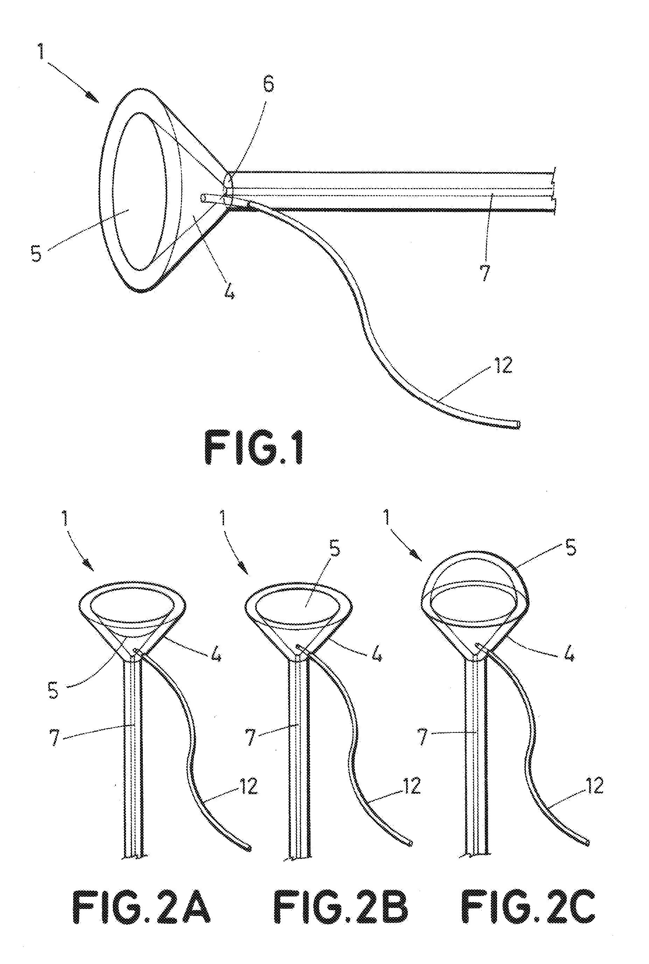

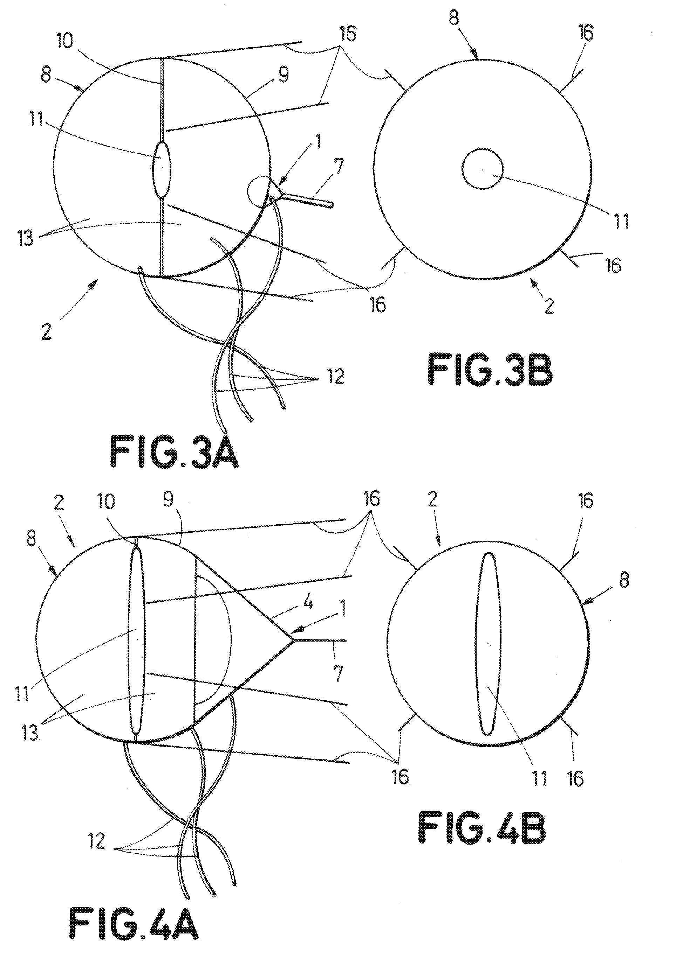

- simple manipulator elements (1), such as those shown in Figures 1 and 2, with a more or less conical configuration,
- optical manipulator elements (2), shown in Figures 3 to 6, having a round configuration since they are formed by bodies which can be spherical, spheroid, ovoid or paraboloid, and which, in most cases, are combined with a simple optical manipulator element (1) incorporated therein,
- or composite optical manipulator elements (3), in which case they are formed by grouping together, as modules, several simple optical manipulator elements (1) and/or several double-reflection optical manipulator elements (2), i.e., jointly or exclusively.

It is important to point out that both the simple optical manipulator elements and the optical manipulator elements have cone-shaped bodies and round bodies (spherical, spheroid, ovoid or paraboloid) or sections or joints thereof that can be made with materials of any type that are transparent or reflective, mixed and used for the purpose of adapting them, together with suitable guide means for guiding light and optical elements, to cover the energy and lighting needs in an optimal manner by creating modular system designs that comply with Snell's law; said bodies can be made of a rigid structure or a flexible structure and in such case, they can be inflated through tubing (12) whereby pressure can also be controlled and shape can be adapted for improved focusing of, and therefore more efficiently capturing and manipulating, the light.

The simple optical manipulator elements (1) are formed by a hollow conical body (4) with a base (5) through which light enters and exits, and a tip (6) to which there are coupled guide means (7), all of which are made of a transparent material having a high refractive index, whereas the rest of the inner surface of said conical body (4) is made of a reflective material with a lower refractive index.

These simple manipulator (1) can have different shapes, including straight, oblique or elliptical cones, and they can also have a pyramidal shape, tetrahedral shape, teardrop shape or any other shape similar to a conical shape, i.e., a pointed end and another much thicker end. In any case, they have an internal cavity, since said cavity works so that the simple optical manipulator is adaptive, to gather and transmit light as efficiently as possible.

The simple optical manipulators (1) are characterized by being formed by conical elements with the insides and the surface of their bases (5) and tips (6) (the thinnest parts) made of plastic (such as polyethylene, PET, polyethylene or PET derivatives or the like) or of glass (germanium and silicon oxide or the like, such as latex and others) having a high refractive index, and by the rest of the surface of the conical body (4) which is a layer of a material similar to the inside, having a slightly lower refractive index, i.e., it is reflective.

The simple optical manipulators (1) have a wall located between their base and the cavity inside same; said wall is transparent and since there is a difference in the thickness thereof, the wall becomes a lens the focal point of which is the output of the simple optical manipulator, i.e., the input of the guide means (7) for guiding light.

It must also be pointed out that the simple optical manipulator elements (1) basically comprise three shapes, depending on the pressure of the cavity inside same, which pressure can be controlled through the aforementioned tubing (12). Furthermore, the following is obtained depending on the shape of the surface of the base (5) of the conical body (4) : concave simple optical manipulator (Figure 2A) when suction is applied to the cavity inside same; planar simple optical manipulator (Figure 2B) when the inner pressure thereof is equal to environmental pressure; convex .simple optical manipulator (Figure 2C) when pressure is applied to the cavity inside the simple optical manipulator.

The double-reflection optical manipulator elements (2) are in turn formed by a hollow round body (8) having two mirrors, in all or in part of the inner surfaces. The larger mirror (9), which, is the reflective half sphere or a parabola, concentrates the light gathered on its focal line or point in the center or along the diameter of the equatorial membrane (10), where the smaller mirror (11) with shapes ranging from a circular shape to a square shape, a concave shape, a conventional shape, or a Fresnel-type mirror, according to its design, is glued or embossed and painted, and has the same curvature as the larger mirror and reflects the light to a simple optical manipulator (1) channeling the light to the guide means (7) thereof. It must be stated that although in most cases double-reflection optical manipulators incorporate a simple optical manipulator, they may optionally not incorporate said simple optical manipulator, in which case the smaller mirror will channel the light directly to the guide means.

Inflatable double-reflection optical manipulator elements (2) incorporate tubing (12) controlling the pressure of the chamber or chambers (13) of the round body (8) determined by the membrane (10).

Figures 3A and 3B show both side and front views of the components of a spherical double-reflection optical manipulator (2) of the type having a short smaller mirror (11), which components are: the transparent surface through which light enters like a collector, or through which light exits like a lamp or flashlight, which is the front of the round body (8), the parabolic larger mirror (9), and in the center of the parabola of the larger mirror (9) there is a simple optical manipulator (1) transferring light to the guide means (7) for guiding light. The smaller mirror (11) is located in the vicinity of the focal line or point/points of the larger mirror (9) of the double-reflection optical manipulator the tubing (12) communicating with the chamber (13) inside the round body (8) of the double-reflection optical manipulator (2), which allow adjusting light capture, controlling the pressure of both chambers, also being seen on both sides of the membrane (10) or support equipment for supporting the smaller mirror (11) of the double-reflection optical manipulator (2), and that of the simple optical manipulator (1). Finally, the double-reflection optical manipulator element (2) has ropes (16) tethering it to the ground.

Figures 4A and 4B show side and front views of the components of a spherical double-reflection optical manipulator (2) of the type having an elongated smaller mirror (11), which components are: the transparent surface through which light enters like a collector, or through which light exits like a lamp or flashlight, which is the front of the round body (8), the parabolic larger mirror (9); there is arranged in the center of the parabola of the larger mirror (9) a simple optical manipulators (1), transferring light to the guide means (7) for guiding light. Behind the focal line of the larger mirror (9), across which the reflection of the sun travels throughout the day, it is reflected in the smaller mirror (11). Furthermore, this example of manipulator also has tubing (12) communicating with the inside of the spherical-type double-reflection optical manipulator having an elongated smaller mirror, which allow adjusting light capture, controlling the pressure of the chambers (13) of the double-reflection optical manipulator (6) and of the simple optical manipulator (1); and finally the ropes (16) tethering the spherical-type double-reflection optical manipulator (2) having an elongated smaller mirror (11) to the ground.

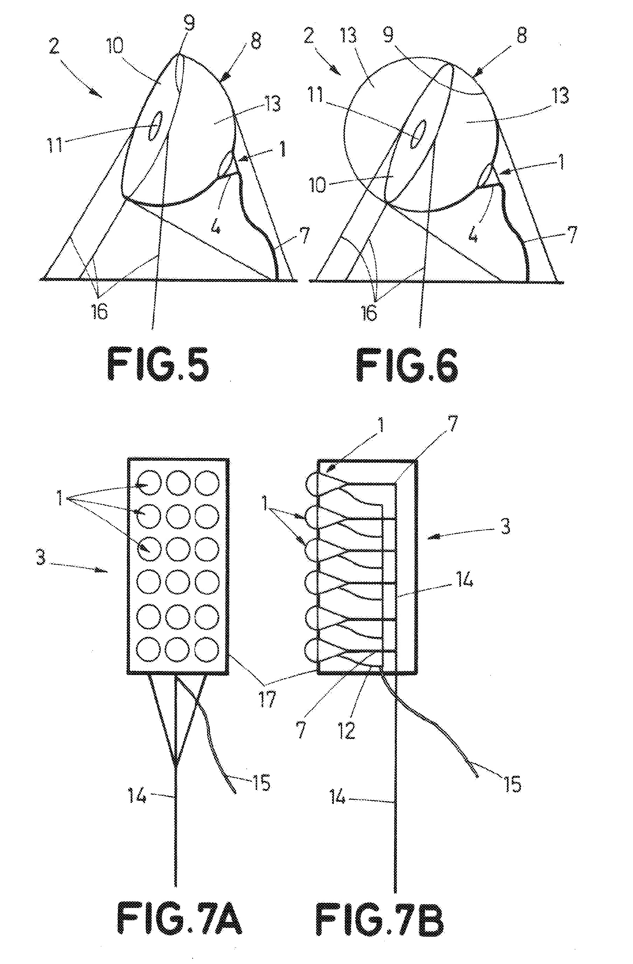

Figures 5 and 6 show, respectively, a parabolic-type double-reflection optical manipulator (2) of the type having a short smaller mirror (11) the round body (8) of which is a section of a sphere, and a spherical double-reflection optical manipulator (2) also of the type having a short smaller mirror (11) the round body (8) of which is a sphere, the difference in the shape of each manipulator being noticeable. The parabolic-type double-reflection optical manipulator (2) of Figure 5 has one less chamber (13) than the spherical-type double-reflection optical manipulator (2) of Figure 6, which takes focusing power away from its mirrors. In a double-reflection optical manipulator 2), focusing is achieved by inflating and deflating the chambers (13) of the round body (8) of said double-reflection optical manipulator, and also by inflating and deflating the inner cavity of the conical body (4) of the simple optical manipulator element (1) that is attached thereto.

Finally, the equipment of the invention comprises composite optical manipulator elements (3) which, as described above, are formed by grouping together, in an exclusive or varied, homogenous or heterogeneous manner, the first two types of optical manipulator elements and their respective subtypes.

To that end, as observed in Figures 7 to 9, they comprise a panel (17) in which there are incorporated several simple optical manipulator elements (1) and/or several double-reflection optical manipulator elements (2), and the respective guide means (7) of which for guiding light are grouped together as the main guide means (14), just as the respective tubing (12) for controlling pressure of said manipulator elements are grouped together as the main tubing (15).

Figures 7A and 7B show front and side views, respectively, of an example of a composite optical manipulator element (3) formed only by several simple optical manipulator elements (1), the arrangement thereof in the panel (17) and the grouping together of the guide means (7) for guiding light as the main guide means (14), as well as the grouping together of the tubing (12) of each of them as the main tubing (15) being seen.

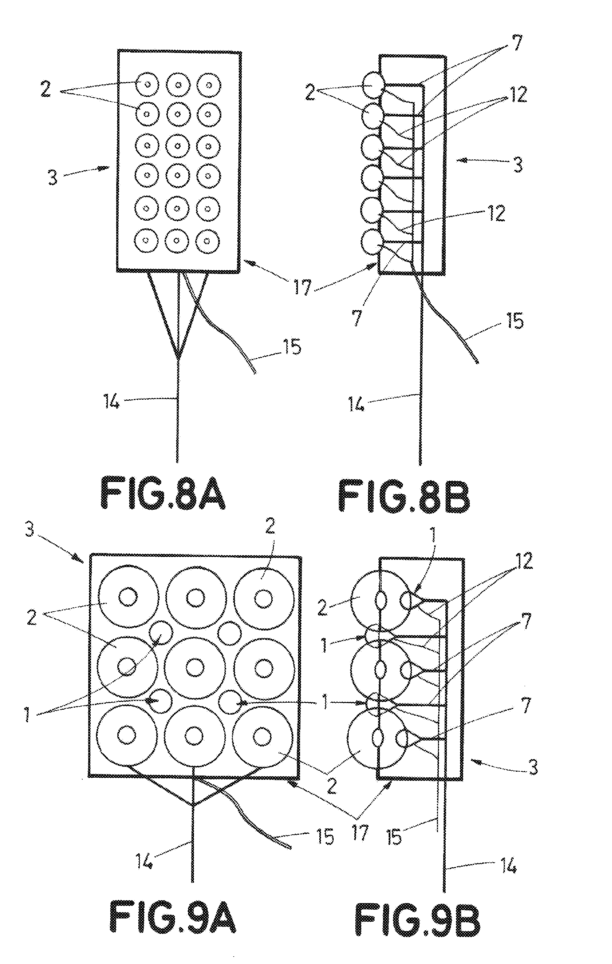

Figures 8A and 8B show another example of a composite optical manipulator element (3), in this case formed only by double-reflection optical manipulator elements (2), the arrangement thereof and the grouping together of the guide means (7) for guiding light and of the tubing (12) as the main guide means (14) and the main tubing (15), respectively, being seen.

Finally, Figures 9A and 9B are an example of a mixed-type composite optical manipulator element (3), i.e., formed by simple optical manipulator elements (1) and double-reflection optical manipulator elements (2) which in turn incorporate, attached thereto, simple optical manipulator elements (1), the arrangement thereof and the components grouping them together being seen.

Having sufficiently described the nature of the present invention as well as the manner of putting it into practice, it is not considered necessary to further describe the invention so that any person skilled in the art can comprehend the scope thereof and advantages derived from it, stating that it could be carried out to practice within its essential features in other embodiments differing in detail from that indicated by way of example, and such embodiments would be covered by the protection that is sought provided that the fundamental principle thereof is neither altered, changed nor modified.

**Claims**

1. A modular, adaptive optical capture and distribution equipment, applicable for capturing light from any source and for being used as a solar collector or as a telescope, **characterized in that** it comprises optical manipulator elements which, formed by devices suitable for gathering light and channeling it to guide means (7) in order to convey said light to the location where it is required, allow controlling the focusing and the intensity of the light output; and **in that** said optical manipulator elements are simple manipulator elements (1) with bodies having a conical configuration, or double-reflection optical manipulator elements (2) with bodies having a round configuration which may be spherical, spheroid, ovoid or paraboloid, and are combined with a simple optical manipulator element (1), or composite optical manipulator elements (3) formed by grouping together, as modules, several simple optical manipulator elements (1) and/or double-reflection optical manipulator elements (2), jointly or exclusively.

2. The modular, adaptive optical capture and distribution equipment according to claim 1, **characterized in that** the simple optical manipulator elements (1) are formed by a hollow conical body (4) with a base (5) through which light enters and exits, and a tip (6) to which there are coupled guide means (7), all of which are made of a transparent material having a high refractive index, whereas the rest of the inner surface of said conical body (4) is made of a reflective material with a lower refractive index.

3. The modular, adaptive optical capture and distribution equipment according to claim 1 or 2, **characterized in that** the double-reflection optical manipulator elements (2) are formed by a round hollow body (8) with two mirrors, a larger mirror (9) occupying the hemisphere or parabola of the inner surface of said body and concentrating the gathered light on its focal line or point/points in the center or along the membrane (10) splitting its interior or forming its base, where there is arranged a smaller mirror (11) which in turn reflects the light directly to the guide means (7) thereof.

4. The modular, adaptive optical capture and distribution equipment according to claim 1 or 2, **characterized in that** the double-reflection optical manipulator elements (2) are formed by a round hollow body (8) with two mirrors, a larger mirror (9) occupying the hemisphere or parabola of the inner surface of said body and concentrating the gathered light on its focal line or point/points in the center or along the membrane (10) splitting its interior or forming its base, where there is arranged a smaller mirror (11) which in turn reflects the light to a simple optical manipulator (1) attached to the round body (8) for that purpose and channels the light to the guide means (7) thereof.

5. The modular, adaptive optical capture and distribution equipment according to any of claims 1-4, **characterized in that** the simple optical manipulator elements (1) and the double-reflection optical manipulator elements (2) are formed by bodies having a rigid structure.

6. The modular, adaptive optical capture and distribution equipment according to any of claims 1-4, **characterized in that** the simple optical manipulator elements (1) and the double-reflection optical manipulator elements .(2) are formed by inflatable bodies having a flexible structure.

7. The modular, adaptive optical capture and distribution equipment according to claim 6, **characterized in that** the simple optical manipulator elements (1) incorporate tubing (12) controlling the pressure of the inner cavity of the conical body (4), allowing changing the surface shape of the base (5).

8. The modular, adaptive optical capture and distribution equipment according to claim 6, **characterized in that** the double-reflection optical manipulator elements incorporate tubing (12) controlling the pressure of the chamber or chambers (13) of the round body (8) determined by the membrane (10) or support equipment for supporting the smaller mirror (11).

9. The modular, adaptive optical capture and distribution equipment according to any of claims 1-8, **characterized in that** the composite optical manipulator elements (3) comprise a panel (17) in which there are incorporated several simple optical manipulator elements (1) and/or several double-reflection optical manipulator elements (2) the respective guide means (7) of which are grouped together as the main guide means (14).

10. The modular, adaptive optical capture and distribution equipment according to any of claims 5-9, **characterized in that** the composite optical manipulator elements (3) incorporate several simple optical manipulator elements (1) and/or several double-reflection optical manipulator elements (2) the respective pressure control tubing (12) of which is grouped together as the main tubing (15).

FIG.1

FIG.2A    FIG.2B    FIG.2C

**FIG.3A**

**FIG.3B**

**FIG.4A**

**FIG.4B**

**FIG.5**

**FIG.6**

**FIG.7A**

**FIG.7B**

FIG.8A

FIG.8B

FIG.9A

FIG.9B

# INTERNATIONAL SEARCH REPORT

| International application No. |
| --- |
| PCT/ES2013/070029 |

**A. CLASSIFICATION OF SUBJECT MATTER**

**See extra sheet**

According to International Patent Classification (IPC) or to both national classification and IPC

**B. FIELDS SEARCHED**

Minimum documentation searched (classification system followed by classification symbols)
G02B, H04B

Documentation searched other than minimum documentation to the extent that such documents are included in the fields searched

Electronic data base consulted during the international search (name of data base and, where practicable, search terms used)

EPODOC, INVENES

**C. DOCUMENTS CONSIDERED TO BE RELEVANT**

| Category* | Citation of document, with indication, where appropriate, of the relevant passages | Relevant to claim No. |
| --- | --- | --- |
| X | ES 291562U U (ELECTROSISTEMAS BACH, S.A.) 16/10/1986, figure, page 3, lines 9-28; página4, lines 15-22 | 1, 5, 9, 10 |
| Y | | 2-4, 6-8 |
| Y | ES 2371879 A1 (UNIV MADRID POLITECNICA ET AL.) 11/01/2012, abstract, figure 4, page 2, lines 57-60; page 4, lines 7-14. | 2 |
| Y | WO 2010017594 A1 (HAHN HARRY) 18/02/2010, figures 1a, 1b, 2, 20, 27, 28c; abstract WPI, abstract EPODOC, page 1, line 4 a page 2, line 13; page 2, line 19 a page 3, line 4; page 19, line 21 a page 20, line 11; page 28, lines 1 a page 29, line 2; page 29, line 31 a page 30, line 10. | 3, 4, 6-8 |

☒ Further documents are listed in the continuation of Box C.   ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means. | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | "&" document member of the same patent family |

| Date of the actual completion of the international search | Date of mailing of the international search report |
| --- | --- |
| 24/05/2013 | **(27/05/2013)** |
| Name and mailing address of the ISA/ | Authorized officer |
| OFICINA ESPAÑOLA DE PATENTES Y MARCAS Paseo de la Castellana, 75 - 28071 Madrid (España) Facsimile No.: 91 349 53 04 | A. López Ramiro |
| | Telephone No. 91 3495322 |

Form PCT/ISA/210 (second sheet) (July 2009)

## INTERNATIONAL SEARCH REPORT

| | International application No. |
|---|---|
| | PCT/ES2013/070029 |

C (continuation). DOCUMENTS CONSIDERED TO BE RELEVANT

| Category * | Citation of documents, with indication, where appropriate, of the relevant passages | Relevant to claim No. |
|---|---|---|
| Y | DE 20121884U U1 (TKADLEC STANISLAV) 10/07/2003, figures 1, 4; abstract WPI, abstract EPODOC, page 1, lines 1-18; claims 1-4. | 6-8 |
| A | ES 1055533U U (AVANCE LUZ S L) 16/12/2003, figures; page 4, claims 1-3. | 1-10 |
| A | ES 1071669U U (NAVAS SANCHEZ ALFONSO GABRIEL) 25/03/2010, figures; page 2, lines 5-31. | 1-10 |

Form PCT/ISA/210 (continuation of second sheet) (July 2009)

## INTERNATIONAL SEARCH REPORT

Information on patent family members

| International application No. |
|---|
| PCT/ES2013/070029 |

| Patent document cited in the search report | Publication date | Patent family member(s) | Publication date |
|---|---|---|---|
| ES291562U U | 16.10.1986 | ES291562Y Y | 16.06.1987 |
| ES2371879 A1 | 11.01.2012 | NONE | |
| WO2010017594 A1 | 18.02.2010 | US2011162637 A1<br>EP2386047 A1<br>AU2009281709 A1 | 07.07.2011<br>16.11.2011<br>18.02.2010 |
| DE20121884U U1 | 10.07.2003 | NONE | |
| ES1055533U U | 16.12.2003 | ES1055533Y Y | 16.04.2004 |
| ES1071669U U | 25.03.2010 | ES1071669Y Y | 21.06.2010 |

Form PCT/ISA/210 (patent family annex) (July 2009)

## INTERNATIONAL SEARCH REPORT

International application No.

PCT/ES2013/070029

### CLASSIFICATION OF SUBJECT MATTER

*G02B26/00* (2006.01)
*G02B6/35* (2006.01)
*H04B10/25* (2013.01)
*G02B23/00* (2006.01)

Form PCT/ISA/210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2758656 Y
- FR 2567995 A1
- GB 2457701 A
- US 4182307 A
- CN 201038321 Y
- DE 19923141 A1
- CN 2768032 Y